Europäisches Patentamt

European Patent Office

Office européen des brevets

(11) Numéro de publication: **0 063 511
B1**

(12) **FASCICULE DE BREVET EUROPEEN**

(45) Date de publication du fascicule du brevet: **19.06.85**

(51) Int. Cl.⁴: **C 22 C 19/05,** C 22 F 1/10

(21) Numéro de dépôt: **82400598.7**

(22) Date de dépôt: **31.03.82**

(54) **Superalliage monocristallin à matrice à base de nickel, procédé d'amélioration de pièces en ce superalliage et pièces obtenues par ce procédé.**

(30) Priorité: **03.04.81 FR 8106782**

(43) Date de publication de la demande:
**27.10.82 Bulletin 82/43**

(45) Mention de la délivrance du brevet:
**19.06.85 Bulletin 85/25**

(84) Etats contractants désignés:
**BE DE GB IT LU NL SE**

(56) Documents cités:
**EP-A-0 052 911
FR-A-2 392 129
GB-A-1 011 785
GB-A-1 260 982**

(73) Titulaire: **Office National d'Etudes et de Recherches Aerospatiales (O.N.E.R.A.)
29 Avenue de la Division Leclerc
F-92320 Châtillon-sous-Bagneux (FR)**

(72) Inventeur: **Khan, Tasadduq
18, parc de Diane
F-78350 Jouy en Josas (FR)**
Inventeur: **Caron, Pierre
13, allée des Bathes
F-91940 Les Ulis (FR)**

(74) Mandataire: **Dupas, Marie-Cécile et al
Cabinet NETTER 40, rue Vignon
F-75009 Paris (FR)**

Courier Press, Leamington Spa, England.

**0 063 511**

**Description**

L'invention concerne des superalliages monocristallins à matrice à base de nickel utilisables notamment pour la fabrication d'aubes mobiles et d'aubes fixes de turbomachines aéronautiques.

Depuis quelques années, de nombreux travaux ont été effectués pour mettre au point des compositions spécifiques destinées soit à l'élaboration de superalliages à grains colonnaires, soit à l'élaboration de superalliages monocristallins.

Les superalliages à grains colonnaires, obtenus par solidification dirigée, s'ils présentent, par rapport aux superalliages de composition analogue à grains équiaxes, des qualités supérieures eu égard à la résistance aux efforts subis dans la direction des plans de joints de grains, ne possèdent pas, par contre, de meilleures propriétés mécaniques à l'égard des efforts transversaux.

L'élaboration de superalliages monocristallins (en particulier du type connu sous le nom MAR-M200) a représenté un progrès important en ce qui concerne la résistance aux efforts s'exerçant dans la direction transversale à la direction de solidification. Mais un gain comparable a pu être obtenu dans des superalliages à grains colonnaires grâce à l'introduction du hafnium dans la composition de ces derniers, de sorte que les travaux sur la solidification monocristalline en ont été pour un temps fortement ralentis.

Récemment, un regain d'intérêt s'est manifesté pour la solidification monocristalline d'alliages de compositions relativement simples, sans addition des éléments carbone, bore et zirconium ajoutés auparavant tant dans les compositions d'alliages monocristallins que dans les compositions d'alliages à grains colonnaires, dans le but, pour ces derniers, de durcir les joints des grains pour éviter des ruptures prématurées en fluage.

La suppression dans les alliages monocristallins de ces derniers éléments, qui contribuent à former, notamment dans les espaces interdentritiques qui se constituent au cours de la solidification, des régions à bas point de fusion, a en effet permis d'élever de façon notable la température de fusion commençante des alliages et a donc permis d'envisager d'appliquer des traitements thermiques à très haute température, notamment aux alliages à base de nickel, pour la mise en solution complète de la phase γ' de type $Ni_3$ (Al, Ti . . .).

Des alliages ont ainsi été mis au point qui peuvent être chauffés à une température suffisamment élevée pour obtenir une mise en solution complète de la phase γ' puis une précipitation contrôlée de cette phase γ' pour en obtenir une fraction volumique très importante, pouvant atteindre 60% et plus.

En particulier, la Demande de brevet français No 2 392 129 décrit un superalliage monocristallin ayant la composition suivante:

Cr  8 à 12%

Al  4,5 à 5,5%

Ti  1 à 2%

W  3 à 5%

Ta  10 à 14%

Co  3 à 7%
le complément étant
essentiellement du nickel,

et les grains de phase γ' ayant une dimension inférieure à 0,5 μ. Ce document décrit également un procédé consistant à traiter un tel alliage à une température comprise entre 1288°C et 1316°C pour mettre en solution la phase γ'.

La Demande de Brevet Européen No 52 911 décrit des alliages monocristallins composés comme suit, compte non tenu des impuretés:

Co  4,3 à 4,9%

Cr  7,5 à 8,2%

Mo  0,3 à 0,7%

W  7,6 à 8,4%

Ta  5,8 à 6,2%

Al  5,45 à 5,75%

Ti  0,8 à 1,2%

Ni  complément.

2

**0 063 511**

Ces alliages sont portés à une température de 1315°C pour mettre en solution la phase γ', puis à des températures de 982°C et 871°C.

Par ailleurs, la dimension des grains des précipités constitue un autre facteur significatif eu égard à la résistance au fluage des alliages: dans le cas de superalliages à base de nickel ayant des fractions volumiques de précipité γ' d'environ 60% ou plus, la dimension optimale des grains du précipité γ' pour une résistance au fluage maximale est généralement de l'ordre de 3000 Å. Mais l'obtention de précipités γ' dont les grains n'excèdent pas une dimension de 3000 Å implique par contre une température de précipitation inférieure à une limite déterminée.

C'est un but de l'invention de fournir un procédé de traitement thermique qui confère à des superalliages monocristallins d'une composition appropriée une résistance exceptionnellement élevée au fluage dans un large domaine de températures.

C'est un autre but de l'invention de fournir une composition de superalliages monocristallins à matrice à base de nickel auxquels il est possible de conférer, par un tel traitement thermique, un accroissement important de leur résistance au fluage dans un large domaine de températures.

Selon l'invention, la composition d'un superalliage monocristallin comprend les éléments suivants, dans les proportions pondérales suivantes:

| | |
|---|---|
| Al | 6,1% |
| Co | 5% |
| Cr | 8% |
| Mo | 0,5% |
| Ta | 6% |
| W | 8% |
| Ni | et impuretés éventuelles complément à 100. |

La mise au point d'une composition d'alliage de ce type n'est nullement immédiate, et ce en raison de la quasi-impossibilité de prévoir avec certitude les effets d'une modification de la teneur en un élément habituellement utilisé, ou les effets de l'addition ou de la suppression d'un élément.

En ce qui concerne le cobalt: d'une manière générale, on a proposé d'introduire du cobalt dans des superalliages pour abaisser l'énergie de défaut d'empilement de la matrice et, par conséquent, augmenter la résistance au fluage; mais on cherche généralement à diminuer la teneur en cobalt ou supprimer cet élément, d'une part pour des raisons d'ordre économique et, d'autre part, afin de supprimer la formation des phases nuisibles (sigma, mu, Laves) bien connues des métallurgistes qu'entraîne la présence de cobalt. Par ailleurs, on connaît des alliages ne contenant pas de cobalt et dans lesquels, cependant, certaines de ces phases nuisibles apparaissent à température moyenne, alors qu'une addition de quelques pour cent de cobalt dans ces alliages supprime la formation de ladite phase.

L'alliage de composition pondérale conforme à l'invention, comprenant du cobalt et profitant donc des avantages qui y sont attachés, ne donne pas naissance à de telles phases nuisibles lors de maintiens de longue durée à des températures élevées.

En ce qui concerne le tungstène: une teneur en tungstène d'au moins 7% permet, d'une part, un durcissement en solution solide de la matrice et, d'autre part, cet élément entre dans la phase γ' en quantité suffisante pour la rendre plus stable aux hautes températures que la phase γ' des superalliages habituels. Bien qu'il soit en proportion élevée, le tungstène n'entraîne pas, en présence de molybdène, l'apparition de phases de type sigma ou mu.

Dans l'alliage selon l'invention, les teneurs en carbone, bore et zirconium large respectivement inférieures à 80 ppm, 50 ppm et 100 ppm, c'est-à-dire nettement inférieures aux teneurs qui pourraient conduire à un abaissement de la température de fusion commençante de l'alliage, lesquelles teneurs étaient habituellement, dans les alliages connus, respectivement 1000 et 1500 ppm de carbone, 100 à 200 ppm de bore et 300 à 1000 ppm de zirconium.

Cet alliage peut être soumis à des traitements thermiques qui conduisent à une amélioration extrêmement importante et inattendue de sa résistance au fluage dans un large domaine de températures, à savoir entre 700 et 1100°C alors que, jusqu'à présent, des améliorations d'ailleurs nettement moins importantes n'avaient pu être obtenues que pour des températures inférieures à 1000°C.

Conformément à l'invention, on accroît notablement les qualités des pièces en un superalliage de la composition ci-dessous:

3

| Al | 5,4 à 6,2% |
| Co | 4 à 7% |
| Cr | 6 à 9% |
| Mo | 0 à 2,5% |
| Ta | 5,5 à 8% |
| Ti | 0 à 1% |
| W | 7 à 9% |
| Ni | et impuretés éventuelles complément à 100 |

eu égard notamment à la résistance au fluage à température élevée, en effectuant la précipitation de la phase γ' de type $Ni_3Al$ -après mise en solution complète de cette phase dans la solution solide—en portant la pièce à une température supérieure à 1000°C, de préférence comprise entre 1020 et 1120°C, puis en la refroidissant. La température de précipitation de la phase γ' est maintenue pendant quelques heures à quelques dizaines d'heures, selon la température choisie.

L'invention prévoit qu'après avoir porté la pièce à une température supérieure à 1000°C pour la précipitation de la phase γ', on soumet la pièce à un traitement thermique complémentaire conduisant à une augmentation de la fraction volumique des précipités de la phase γ'. Ce traitement thermique complémentaire est de préférence conduit à une température de l'ordre de 850°C.

Les diverses étapes de refroidissement prévues dans la mise en oeuvre du procédé selon l'invention peuvent avoir lieu soit à l'air, jusqu'à la température ambiante, soit dans un four, la pièce étant directement amenée de la température d'un premier traitement thermique (pour la mise en solution ou la précipitation de la phase γ') à la température d'un traitement thermique ultérieur.

Les meilleurs résultats de tenue au fluage, pour des superalliages du type considéré ici, étant généralement obtenus par des traitements de précipitation de la phase γ' faisant intervenir des températures comprises entre 800 et 980°C pour conduire à une dimension des gains du précipité γ' d'environ 3000 Å, un traitement de précipitation faisant intervenir une température supérieure à 1000°C qui entraîne, comme connu, une augmentation de la dimension des grains du précipité, devrait conduire à une diminution de la résistance au fluage des alliages.

Au contraire, un tel traitement d'un superalliage selon l'invention, bien qu'il conduise à une dimension des grains du précipité supérieure à 3000 Å et atteignant environ 5000 Å permet d'aboutir d'une manière surprenante à une amélioration considérable du comportement en fluage au cours d'une utilisation entre 700 et 1100°; la durée de vie de l'alliage peut ainsi être multipliée par un facteur allant jusqu'à 2 ou 3.

Par ailleurs, un traitement thermique de précipitation à température élevée, de l'ordre de 1020 à 1120°C, après mise en solution de la phase γ' à très haute température, permet, à cette température élevée, d'effectuer simultanément plus aisément les traitements de protection de surface, par exemple par aluminisation, souhaitables pour de tels superalliages, et ce, sans pour autant diminuer les caractéristiques mécaniques de l'alliage obtenu finalement.

Les alliages destinés au traitement selon l'invention sont solidifiés sous forme monocristalline selon la direction de croissance cristallographique <001> dans des appareils de solidification à fort gradient thermique (100 à 250°/cm) tel que celui utilisé par exemple pour la solidification dirigée de superalliages du type à fibres de renforcement en monocarbure métallique, comme décrit dans les Brevets français 69 12452 et 76 24539 du même Demandeur. L'alliage monocristallin est obtenu soit en partant d'un germe monocristallin, soit en ajoutant dans la partie inférieure de l'appareil un système de sélection de grains permettant d'obtenir à sa sortie un seul grain orienté selon la direction cristallographique <001>. La température du milieu métallique liquide est d'environ 1650°C et la solidification est réalisée à une vitesse de déplacement du front de solidification comprise entre 10 et 40 cm/h.

Les alliages monocristallins destinés au traitement selon l'invention peuvent également être obtenus en utilisant le procédé exothermique décrit dans L. Sink, G. S. Hoppin III et M. Fujii, NASA CR 159 464, Janvier 1979.

Ces alliages monocristallins sont ensuite soumis à un traitement thermique de mise en solution complète de la phase γ', traitement réalisé entre 1305 et 1325°C selon la composition exacte choisie, pendant environ 30 minutes. Les alliages sont ensuite refroidis à l'air jusqu'à température ambiante.

Ils sont ensuite soumis à un traitement de précipitation de la phase γ', ce traitement faisant intervenir, conformément à l'invention, un maintien pendant quelques heures à une température comprise entre 1020 et 1120°C: pour un traitement à 1020°C, la dimension moyenne des grains du précipité est encore d'environ 3000 Å; elle est d'environ 5000 Å pour un traitement effectué à 1050°C ou plus; dans les deux cas, les précipités obtenus sont alignés selon une direction cristallographique bien définie.

4

# 0 063 511

Dans les exemples ci-après, les alliages ont été soumis, à titre comparatif, à un traitement de précipitation de la phase γ' faisant intervenir une température maximale comprise entre 850 et 980°C pendant quelques heures: les grains du précipité γ', d'une dimension moyenne d'environ 3000 Å, ne sont alors pas alignés selon une direction cristallographique définie.

Exemple 1

On élabore un alliage, dénommé quelquefois par la suite *"alliage A"* ayant la composition pondérale suivante:

| | |
|---|---|
| Co | 5% |
| Cr | 8% |
| Mo | 0,5% |
| W | 8% |
| Al | 6,1% |
| Ta | 6% |
| Ni | et impuretés éventuelles complément à 100 |

L'alliage est élaboré par solidification dirigée, la vitesse du front de solidification étant de 15 cm/heure.

La masse volumique de l'alliage élaboré est d'environ 8.54 g/cm³.

Sa température de fusion commençante est de 1321±3°C.

A partir de cet alliage, on a préparé deux éprouvettes dont l'une a été soumise à un premier traitement thermique et l'autre à un second traitement thermique, définis comme ci-après, et les éprouvettes traitées ont été soumises ensuite à des essais de fluage.

Traitement thermique N° 1

L'éprouvette a été portée à 1315°C pendant 30 minutes puis ensuite refroidie à l'air.

Elle a été portée, au cours d'un deuxième stade, à 950°C pendant 5 heures, puis refroidie à l'air.

Elle a, dans un troisième stade, été portée à 850°C pendant 48 heures.

On a constaté la formation d'un précipité de la phase γ' dont les grains ont une dimension moyenne d'environ 3000 Å.

La figure l*a* est une micrographie d'une section de l'éprouvette obtenue à un grossissement de 7000.

Traitement thermique N° 2

Dans un premier stade, l'éprouvette a été portée à 1315°C et maintenue à cette température pendant 30 minutes. Elle a été ensuite refroidie à l'air.

Au cours d'un second stade, elle a été portée à 1050°C pendant 16 heures puis refroidie à l'air.

Dans un troisième stade, elle a été portée à 850°C pendant 48 heures.

Il a été constaté sur l'éprouvette complètement traitée que les grains du précipité γ' ont une dimension moyenne égale à 5000 Å.

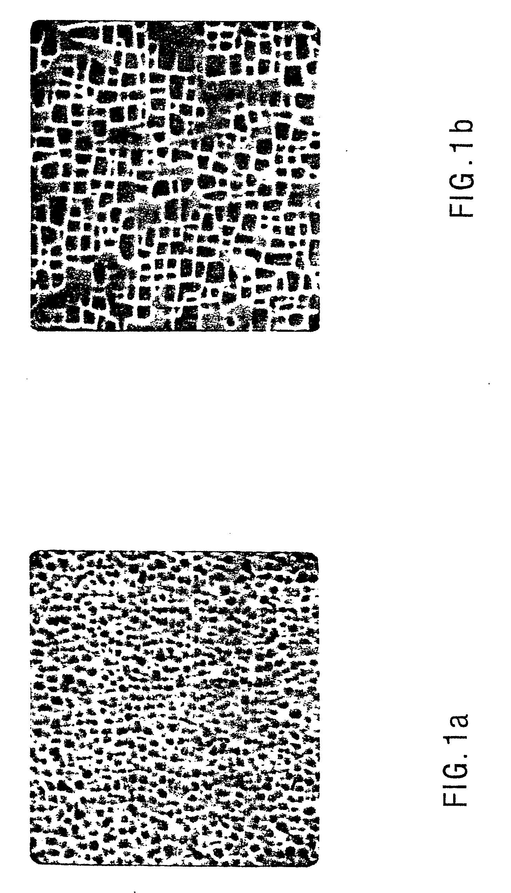

La figure 1*b* est une micrographie d'une section de l'éprouvette prise également à un grossissement de 7000.

On constate que les précipités sont parfaitement alignés selon la direction cristallographique <001>.

Des essais de fluage ont ensuite été effectués sur l'une et l'autre des éprouvettes ayant subi respectivement le traitement thermique N° 1 et le traitement thermique N° 2. Les mêmes essais ont été effectués sur une éprouvette en un superalliage à grains colonnaires connu sous le nom DS200+Hf.

Les résultats de ces essais font l'objet du Tableau 1 ci-après.

5

# 0 063 511

## TABLEAU 1

| Température (°C) | Contrainte (MPa) | Temps de fluage t(heures) | Alliage DS200+Hf | Alliage A (monocristal) | |
|---|---|---|---|---|---|
| | | | | traitement thermique (1): 1315°C/ 30 mn+ 980°C/5h+ 850°C/48h | traitement thermique (2): 1315°C/ 30 mn+ 1050°C/16h+ 850°C/48h |
| 850 | 500 | t pour 1% de déforma-tion. | 40 h | 20 heures | 42 heures |
| | | t à rupture | 100 h | 124 heures | 252 heures |
| 1050 | 140 | t pour 1% de déforma-tion. | 15 h | 60 heures | 86 heures |
| | | t à rupture | 40 h | 112 heures | 200 heures |

Des essais effectués, il ressort que l'alliage A soumis au traitement selon l'invention (traitement thermique N° 2) montre à 850°C une durée de vie environ 2,5 fois plus élevée que l'alliage à grains colonnaires DS200+Hf. A 1050°C et sous une contrainte de 140 MPa, l'alliage A présente une durée de vie 5 fois supérieure à celle de l'alliage DS200+Hf.

Ces résultats sont obtenus bien que l'alliage A selon l'invention ne comporte pas de titane alors qu'il était très généralement admis jusqu'à présent que, pour les superalliages destinés à la fabrication d'aubes de turbines à très haute résistance au fluage, comme l'est l'alliage A, des teneurs en titane allant de 1 à 4% en poids étaient indispensables pour obtenir les qualités requises: la présence de titane a en effet pour résultat de diminuer l'énergie de défaut d'empilement des précipités γ' et de conduire ainsi à une meilleure résistance au fluage.

L'alliage selon l'invention, tout en présentant des qualités exceptionnelles de résistance au fluage à chaud, est dépourvu des inconvénients liés à la présence du titane, à savoir, au cours de la fabrication, une forte réactivité à l'égard du matériau constitutif des creusets industriels utilisés pour l'élaboration de l'alliage et, au cours de l'utilisation, diminution de la résistance à l'oxydation et à la corrosion.

Exemple 2

On élabore par solidification dirigée, le front de solidification progressant à 15 cm/heure, un alliage monocristallin dénommé ci-après *"alliage B"* de composition pondérale suivante:

Co=5%
Cr=8%
Mo=0,5%
W=8%
Al=5,5%
Ti=1%
Ta=6%
Ni et impuretés éventuelles=complément à 100

La masse volumique de cet alliage est 8,59 g/cm$^3$ et sa température de fusion commençante 1328°C±3°C.

Des éprouvettes de l'alliage B sont soumises respectivement au traitement n° 1 et au traitement n° 2 définis ci-dessus dans l'exemple 1.

Après le traitement n° 1, on constate que la dimension moyenne des grains du précipité γ' est d'environ 3000 Å.

Elle est d'environ 5000 Å après le traitement n° 2.

On constate également que, comme pour l'alliage A, les grains du précipité γ' de l'alliage B soumis au traitement n° 1 ne sont pas alignés alors que les grains du précipité γ' de l'alliage B soumis au traitement n° 2 sont parfaitement alignés selon une direction cristallographique <001>.

Ces éprouvettes en l'alliage B soumises respectivement aux traitements n° 1 et n° 2 ont subi des essais de fluage dont les résultats sont rapportés dans le tableau 2 ci-après, comparativement à ceux obtenus pour l'alliage connu à grains colonnaires DS200+Hf.

6

# 0 063 511

TABLEAU 2

| Température (°C) | Contrainte (MPa) | Temps de fluage t (heures) | Alliage DS200+Hf | Alliage B (monocristal) | |
|---|---|---|---|---|---|
| | | | | Traitement thermique (1) | Traitement thermique (2) |
| 760 | 750 | t pour 1% de déformation. | 10 h | 48 h | 110 h |
| | | t à rupture | 60 h | 450—500 h | 1000 h |
| 950 | 240 | t pour 1% de déformation. | 45 h | 105 h | 150 h |
| | | t à rupture | 170 h | 310 h | 450 h |
| 1050 | 120 | t pour 1% de déformation. | 32 h | 330 h | 700—800 h |
| | | t à rupture | 100 h | 470 h | 1000—1200 h |

Les résultats ressortant du tableau 2 montrent également le gain considérable en résistance au fluage dans le domaine de températures 760—1050°C obtenu par le traitement thermique selon l'invention (traitement thermique n° 2).

Jusqu'à présent, des gains aussi importants en durée de vie dans un domaine de températures aussi large, pour des superalliages de ce type, n'ont jamais été signalés.

Par ailleurs, des examens effectués sur diverses éprouvettes fabriquées à partir d'alliages selon l'invention et/ou ayant été soumises au traitement thermique selon l'invention n'ont pas permis de constater, après des essais de fluage à diverses températures comprises entre 760 et 1050°C, la présence des phases nuisibles connues sous le nom de sigma, mu et Laves. Les alliages ayant subi le traitement selon l'invention présentent donc une très bonne stabilité thermique dans leurs divers domaines d'emploi.

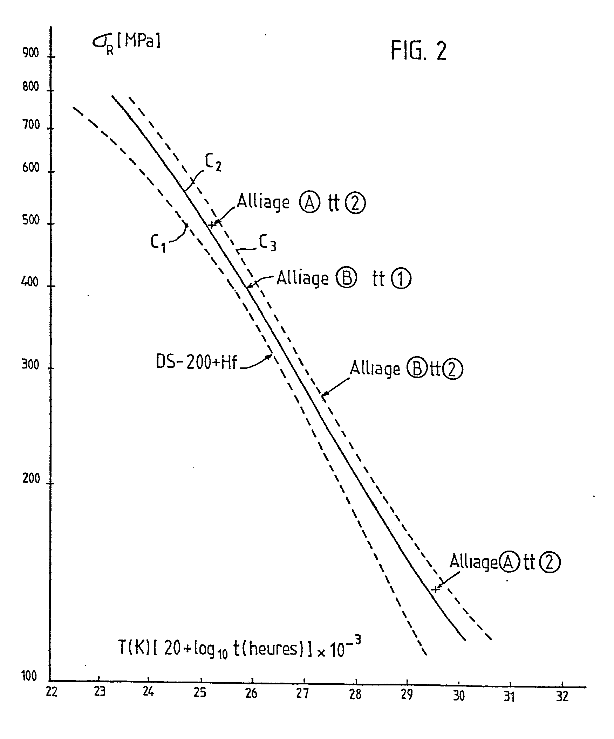

La figure 2 montre des courbes représentatives de la variation du paramètre de Larson-Miller, à savoir

$$P=T(K)[20+\log_{10}t(h)]\times10^{-3}$$

en fonction de la contrainte $\sigma_R$ (en MPa).

La courbe $C_1$ est relative à l'alliage à grains colonnaires connu sous le nom de DS200+Hf.

La courbe $C_2$ concerne l'alliage B soumis au traitement thermique n° 1.

La courbe $C_3$ est relative à l'alliage B soumis au traitement thermique selon l'invention (Traitement n° 2).

Ces courbes confirment les résultats portés sur le tableau n° 2: le traitement thermique selon l'invention améliore très nettement les qualités de résistance au fluage de l'alliage B.

Des essais ont été effectués sur des éprouvettes en alliage A selon l'invention et soumis au traitement thermique No 2 selon l'invention. Les valeurs correspondantes ont été portées sous forme de crois sur la figure 2; cet alliage, bien que ne comprenant pas de titane, présente une excellente tenue au fluage à moyenne et à haute température.

L'alliage selon l'invention est particulièrement bien adapté pour la fabrication d'aubes de turbines pour l'industrie aéronautique.

Le traitement thermique selon l'invention est particulièrement avantageux dans le cas où l'alliage est destiné à l'obtention d'aubes de turbines.

## Revendications

1. Procédé pour améliorer la résistance au fluage d'une pièce en un superalliage monocristallin à matrice à base de nickel dont la composition en poids est la suivante:

7

| Al | 5,4 à 6,2 |
|----|-----------|
| Co | 4 à 7% |
| Cr | 6 à 9% |
| Mo | 0 à 2,5% |
| Ta | 5,5 à 8% |
| Ti | 0 à 1% |
| W  | 7 à 9% |
| Ni | et impuretés éventuelles compléments à 100 |

comprenant le chauffage de la pièce à la température de mise en solution complète de la phase γ' de type Ni₃Al, caractérisé en ce qu'après ce chauffage la pièce est portée à une température supérieure à 1000°C à laquelle s'effectue la précipitation de la phase γ' dans la solution solide γ.

2. Procédé selon la revendication 1, caractérisé en ce que la précipitation de la phase γ' a lieu en maintenant la pièce à une température comprise entre 1020 et 1120°C.

3. Procédé selon l'une quelconque des revendications 1 et 2, caractérisé en ce que la pièce obtenue après le traitement de précipitation est soumise à un traitement thermique complémentaire conduisant à une augmentation de la fraction volumique du précipité γ'.

4. Procédé selon la revendication 3, caractérisé en ce que pour ce traitement thermique complémentaire la pièce est portée à une température de l'ordre de 850°C.

5. Procédé selon l'une quelconque des revendications précédentes, caractérisé en ce qu'entre deux traitements à des températures différentes on refroidit la pièce à l'air, jusqu'à température ambiante.

6. Procédé selon l'une des revendications 2 à 4, caractérisé en ce que pour soumettre la pièce à deux traitements thermiques, elle est directement amenée de la température du premier traitement à la température du second traitement.

7. Procédé selon l'une quelconque des revendications précédentes, caractérisé en ce qu'au cours du maintien de la pièce à la température de précipitation de la phase γ', on effectue simultanément un traitement de protection de surface de type usuel.

8. Superalliage monocristallin à matrice à base de nickel, caractérisé en ce que sa composition est la suivante (en poids):

| Al | 6,1% |
|----|------|
| Co | 5% |
| Cr | 8% |
| Mo | 0,5% |
| Ta | 6% |
| W  | 8% |
| Ni | et impuretés éventuelles complément à 100. |

9. Pièce en un superalliage selon la revendication 8.

10. Pièce en superalliage obtenue par le procédé selon l'une des revendications 1 à 7.

11. Aube de turbine selon l'une des revendication 9 et 10.

**Patentansprüche**

1. Verfahren zur Verbesserung des Kriechwiderstandes eines Werkstückes, bestehend aus einer monokristallinen Superlegierung in Matrixform auf Nickelbasis mit folgender Zusammensetzung in Gewichtsanteilen:

| | |
|---|---|
| Al | 5,4 bis 6,2% |
| Co | 4 bis 7% |
| Cr | 6 bis 9% |
| Mo | 0 bis 2,5% |
| Ta | 5,5 bis 8% |
| Ti | 0 bis 1% |
| W | 7 bis 9% |

Rest Nickel und ggf. Verunreinigungen,

bei dem das Werkstück auf eine Temperatur erhitzt wird, um die γ'-Phase vom Typ Ni₃Al vollständig in Lösung zu bringen, dadurch gekennzeichnet, daß das Werkstück nach dieser Erhitzung auf eine Temperatur oberhalb von 1000°C gebracht wird, bei der die Ausfällung der γ'-Phase in die feste Lösung γ erfolgt.

2. Verfahren nach Anspruch 1, dadurch gekennzeichnet, daß die Ausfällung der γ'-Phase dadurch bewirkt wird, daß das Werkstück einer Temperatur zwischen 1020 und 1120°C ausgesetzt wird.

3. Verfahren nach Anspruch 1 oder 2, dadurch gekennzeichnet, daß das nach dem Ausfällprozeß erhaltene Werkstück einer ergänzenden thermischen Behandlung unterworfen wird, die zu einer Erhöhung des Volumenanteils des γ' Niederschlags führt.

4. Verfahren nach Anspruch 3, dadurch gekennzeichnet, daß das Werkstück zu dieser ergänzenden thermischen Behandlung einer Temperatur von etwa 850°C ausgesetzt wird.

5. Verfahren nach einem der vorhergehenden Patentansprüche, dadurch gekennzeichnet, daß in der Zeit zwischen zwei Behandlungen bei unterschiedlichen Temperaturen das Werkstück an der Luft bis auf Raumtemperatur abgekühlt wird.

6. Verfahren nach einem der Ansprüche 2—4, dadurch gekennzeichnet, daß man, um das Werkstück zwei thermischen Behandlungen auszusetzen, es unmittelbar von der Temperatur der ersten Behandlung auf die Temperatur der zweiten Behandlung bringt.

7. Verfahren nach einem der vorhergehenden Ansprüche, dadurch gekennzeichnet, daß man gleichzeitig eine übliche Behandlung zum Oberflächenschutz vornimmt, während sich das Werkstück auf der Temperatur zur Ausfällung der γ'-Phase befindet.

8. Monokristalline Legierung in Matrixform auf Nickelbasis, gekennzeichnet durch folgende Zusammensetzung (in Gewichtsprozenten):

| | |
|---|---|
| Al | 6,1% |
| Co | 5% |
| Cr | 8% |
| Mo | 0,5% |
| Ta | 6% |
| W | 8% |

Rest Nickel und ggf. Verunreinigungen.

9. Werkstück aus einer Legierung gemäß Anspruch 8.

10. Werkstück aus einer Legierung, die gemäß dem Verfahren nach einem der Ansprüche 1—7 erhalten wird.

11. Turbinenschaufel gemäß einem der Ansprüche 9 und 10.

9

**Claims**

1. A method of increasing the resistance to creep of a part made from a monocrystalline superalloy with a nickel based matrix and having the following composition by weight:

Al    5.4% to 6.2%

Co    4% to 7%

Cr    6% to 9%

Mo    0% to 2.5%

Ta    5.5% to 8%

Ti    0% to 1%

W    7% to 9%

Ni and any impurities balance to 100%,

including heating the part to a temperature suitable for putting all its $\gamma'$ phase of the $Ni_3Al$ type into solution, and characterised in that after this heating the part is raised to a temperature greater than 1000°C at which the $\gamma'$ phase is precipitated into the $\gamma$ solid solution.

2. A method according to claim 1, characterised in that the $\gamma'$ phase is precipitated by maintaining the part at a temperature lying in the range 1020°C to 1120°C.

3. A method according to claim 1 or 2, characterised in that the part obtained after the precipitation treatment is subjected to a supplementary heat treatment to increase the proportion of its volume which is occupied by $\gamma'$ precipitate.

4. A method according to claim 3, characterised in that the supplementary heat treatment takes place at a temperature of about 850°C.

5. A method according to any preceding claim, characterised in that between two treatments at different temperatures, the part is cooled in air down to ambient temperature.

6. A method according to any one of claims 2 to 4, characterised in that to subject the part to two heat treatments, the part is directly taken from the temperature of the first treatment to the temperature of the second treatment.

7. A method according to any preceding claim, characterised in that a standard type of surface protection treatment is applied to the part while it is being maintained at the temperature for $\gamma'$ phase precipitation.

8. A monocrystalline superalloy with a nickel based matrix characterised in that it has the following composition by weight:

Al    6.1%

Co    5%

Cr    8%

Mo    0.5%

Ta    6%

W    8%

Ni and any impurities balance to 100%.

9. A part made of a superalloy according to claim 8.

10. A part made of a superalloy obtained by the method according to any one of claims 1 to 7.

11. A turbine blade according to claim 9 or 10.

FIG.1a

FIG.1b

0 063 511

FIG. 2

$\sigma_R$ [MPa]

$C_2$

Alliage (A) tt (2)

$C_1$

$C_3$

Alliage (B) tt (1)

DS-200+Hf

Alliage (B) tt (2)

Alliage (A) tt (2)

$T(K)[20+\log_{10} t(\text{heures})] \times 10^{-3}$

2